# EUROPEAN PATENT APPLICATION

(11) **EP 2 420 858 A1**
(43) Date of publication of application: **22.02.2012**
(21) Application number: 10275085.8
(22) Date of filing: 17.08.2010
(51) Int. Cl.: G01S 7/03, H03K 17/76, H03G 11/02, G01S 7/36

(54) **PIN diode limiter integrated in LNA**

(71) Applicant: BAE SYSTEMS plc, London SW1Y 5AD (GB)
(72) Inventor: The designation of the inventor has not yet been filed

(57) **Abstract**

A RADAR Receiver apparatus is described comprising an antenna arranged to receive a signal, an amplifier arranged to amplify a said signal and a signal limiter device for limiting an input signal to the amplifier, wherein the signal limiter is integrated into the amplifier.

The integration of the signal limiter into the receiver apparatus limits signal leakage and protects the receiver input.

## Description

The present invention relates to an improved protection device for protecting a receiver of signals, or signal receiver, and particularly but not exclusively to protecting a device for receiving RADAR signals and to an improved process for receiving those signals.

There are many applications in the prior art using the reflection of RF (radio frequency) or microwave frequency signal across a relatively wide range of different frequencies for purposes of establishing ranging details about an area or target. The RF (radio frequency) or microwave frequency signals are synthesised or generated for the purpose of transmission.

The transmitted microwave or radio frequency signals are sent as a series of pulses towards a target region. The pulses are reflected back to a receiver from the target and information regarding the position and size of the target can be ascertained.

Conventional radar transmits an RF signal at a single frequency and detects energy which is returned from objects in the path of the transmitted RF signal. This returned energy is received by an antenna and is subsequently used to derive information about the detected objects such as their location together with their direction and speed of travel.

By coordinating this measurement with the elevated and azimuth directions of the transmitted signal, it is possible to determine the position of the object with respect to the radar and to track the position of the object in time.

Accurate measurement of distance and position require high-performance electronics. It is important to design the receiver modules carefully to arrive at a low noise figure and to avoid damage to the receiver module from incoming spurious signal pulses such as microwave pulses from external interference or from the Radar's own transmitter circuitry. Protection of low noise amplifiers and other key components of a Radar system from excessive transmit signal leakage and high level interfering and jamming signals external to the Radar, is essential to Radar operation. Thus it is known to provide a filter device module and a separate limiter to reduce damage to the receiver module however, introducing a filter device increases the noise figure to the receiver module circuit and can thus affect the receiver performance.

Known filter systems include the use of a PN junction diode. For a PN junction diode, when the P (positive) and N (negative) doped materials are joined together, the boundary interface where the two regions meet forms a junction with a depleted region, and some of the free electrons cross the junction and connect to the free holes. A charge is set up at the junction preventing any further electrons from crossing over into the region. Energy is required to overcome the forces set up by this charge, and energy such as a small bias voltage is required to overcome the charge. Thus the forward-bias and the reverse-bias properties of the PN junction act as a diode. For design of a limiter at microwave frequencies a PN junction diode with a fast time carrier diode such as the Schottky type can be used, and often two diodes are required to provide full limiting capabilities. This would necessarily be a very complex design, and would be difficult to obtain the required small signal low insertion loss for the system. Furthermore, a Schottky diode provides limiting by a clipping action on the signal however this can lead to effects such as harmonic distortion as harmonics are introduced into the receiver.

We have now devised an improved receiver protection system thus an improved performance receiving module, with a built in overload protection.

According to a first aspect, the present invention provides a receiver apparatus comprising an antenna arranged to receive a signal, an amplifier arranged to amplify a signal and a signal limiter device for limiting an input signal to the amplifier, wherein the signal limiter is integrated into the amplifier.

The integration of the signal limiter into the receiver apparatus thus limits transmit signal leakage and protects the receiver input of the radar or communications system from high levels of interference that could damage the receiver components.

The addition of the signal limiter within the amplifier necessarily results in an additional receiver protector adding to the system noise figure. It has been found that in arrangements according to the preferred embodiment of the invention the small signal insertion loss will be comparatively small compared with conventional known limiting modules, such as filters.

Furthermore the apparatus according to the present invention provides a compact arrangement which has a negligible impact to the noise figure that does not add significantly to the complexity or cost of the system.

Due to the low insertion loss there is no need to balance that loss correspondingly with an increase in transmit power, thus saving power and associated physical size as well as substantially more cost. The signal limiter, a PIN diode limiter in the embodiment described acts to limit the input signal to the amplifier. In addition, a fast current limiter can be provided to protect the receiver apparatus from other signal spikes within the circuit, such as may be output by a transistor, and which may cause heating of circuit components.

Further preferred features of the invention are defined in the accompanying claims.
Figure 1 is a schematic representing a conventional approach to providing receiver protection;
Figure 2 is a schematic representing the protection system and circuit of the present invention;
Figure 3 shows the protection component and limiter circuit of the system of Figure 2;
Figure 4a shows the protection system incorporated into a first configuration;
Figure 4b shows the protection system of the present invention incorporated into an alternative configuration;
Figure 5a shows a schematic illustration of the basic construction of a PIN diode;
Figure 5b shows a component diagram representing a PIN diode in a forward bias state;
Figure 5c shows a component diagram representing a PIN diode in a reverse bias state;
Figure 6a shows the circuit diagram of a protection circuit installed in a RADAR system according to the present invention;
Figure 6b shows the transmitter of the circuit and system of Figure 6a; and
Figure 6c shows the receiver of the circuit and system of Figure 6a.

A receiver module comprises a low noise amplifier (LNA) for increasing the amplitude of the radio wave or microwave reflected back from a target and received at the receiver module.

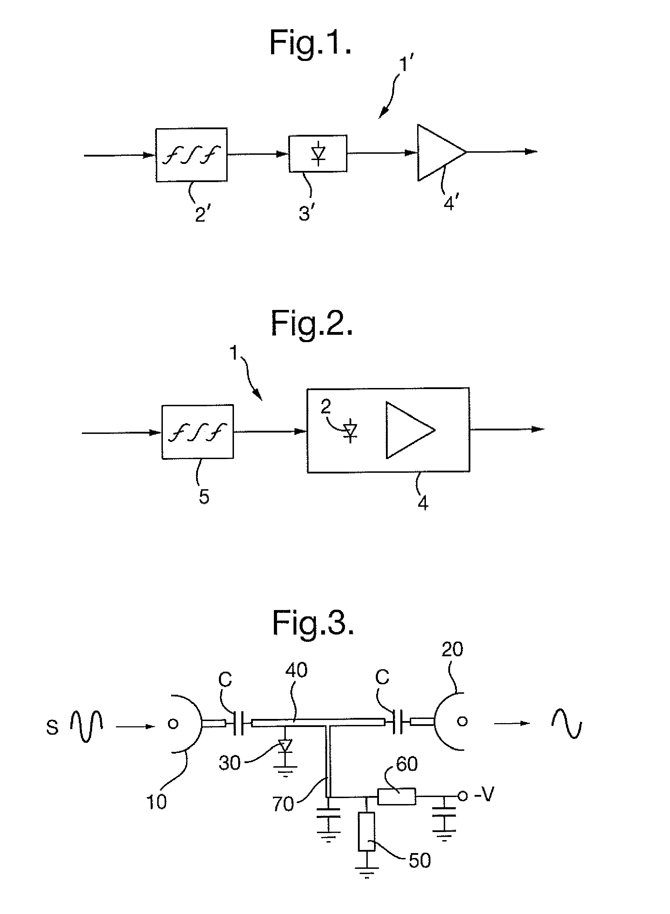

Referring to Figure 1 of the drawings, there is illustrated a conventional approach to limiting the signal input to the receiver apparatus. The apparatus 1' comprises a filter selected to match the input band of the signal of the apparatus 2', a limiter module 3' and a low noise amplifier 4'. The low noise amplifier 4' comprises a high frequency transistor component. The conventional approach illustrated shows individual components having separate functions. Referring now to Figure 2 of the drawings, there is illustrated a receiver apparatus 1 according to an embodiment of the present invention. The receiver protection limiter 2 is integrated within the low noise amplifier 4, and an input band select filter 5 is located upstream of the low noise amplifier 4. The low noise amplifier 4 comprises a type of high frequency transistor, such as a rf or microwave device. The input band select filter 5 allows receipt of an incoming radio wave or microwave signal from a target.

Other types of LNA exist in which a suitable limiter device could be used. For example in an alternative embodiment the LNA may be a low noise HEMT (High electron mobility transistor). Other alternatives (not shown) are a Si HBT silicon heterojunction bipolar transistor, a GASFET gallium arsenide field effect transistor, an InGAP indium gallium phosphide hetrojunction transistor. Finally low noise amplifier module can be implemented such as a monolithic microwave integrated circuit (MMIC), instead of the high frequency transistor.

A low noise HEMT device can provide a good solution for a LNA at microwave frequencies, as it can provide a very low noise figure as well as high gain. By way of explanation the HEMT device has a specialised PN heterojunction, which uses different materials at each side of the junction, typical materials used are depleted n-AlGaAs and GaAs. GaAs is used in the construction because it provides a high level of electron mobility, which is crucial to the operation of the device at microwave frequencies. The low noise figure of the HEMT is attributed to a low amount of electron collisions within the thin conducting channel of the device. The conducting channel is thin in order to provide the high electron mobility which controls the conductivity of the device. The function of a LNA input limiter would be required to prevent the microwave input from exceeding the negative gate threshold voltage of the HEMT device and high power microwave pulses that could permanently damage the HEMT. A design modification to a limiter for use with an HEMT device may be required in order to protect the HEMT's input from damage from incoming microwave pulses from external interference or the transmitter circuitry itself. Depending on the magnitude and duration of the pulse the resulting damage might cause deterioration in the LNA performance.

Filter systems designed with a single transistor LNA, in particular where a cable length to the circuit is greater than 5 cm, recommend use of an isolator device (or a circulator device with external load connected to 3^{rd} port P) to absorb undesirable frequency reflections.

Turning now to Figure 3 the limiter 2 of the present invention is illustrated in further detail with incoming signal S. The limiter 2 comprises an active and biased PIN limiter diode circuit comprising antenna 10 for collecting incoming radio frequency signal, a signal transmitter 20 for transmitting radio frequency signal to the low-noise amplifier 4 and active biased PIN diode 30. A 50 ohm resistance micro-strip 40 and two capacitors (C) comprise the connecting link between the PIN diode 30 and antenna 10 and transmitter 20.

The reverse bias over the PIN diode 30 comprises a negative voltage bias across resistor 50 and resistor 60 arranged in series with the PIN diode 30. The diode 30 acts as a slow short circuit, preventing current flow progressing further. In the preferred embodiment the micro-strip 40 has a resistance of 50 ohms, the resistor 50 has a resistance of 82 ohms and resistor 60 has a resistance of 220 ohms. Connection between micro-strip 40 and the negative voltage bias circuit 80 is provided by quarter wavelength micro-strip 70. In the preferred embodiment the quarter wave length micro-strip 70 has a resistance of 10 ohms. It is to be understood that other resistance values could be chosen as appropriate as known by one skilled in the art.

In the illustrated embodiment (Figure 3) the LNA comprises a PHEMT (Pseudomorphic High electron mobility transistor).

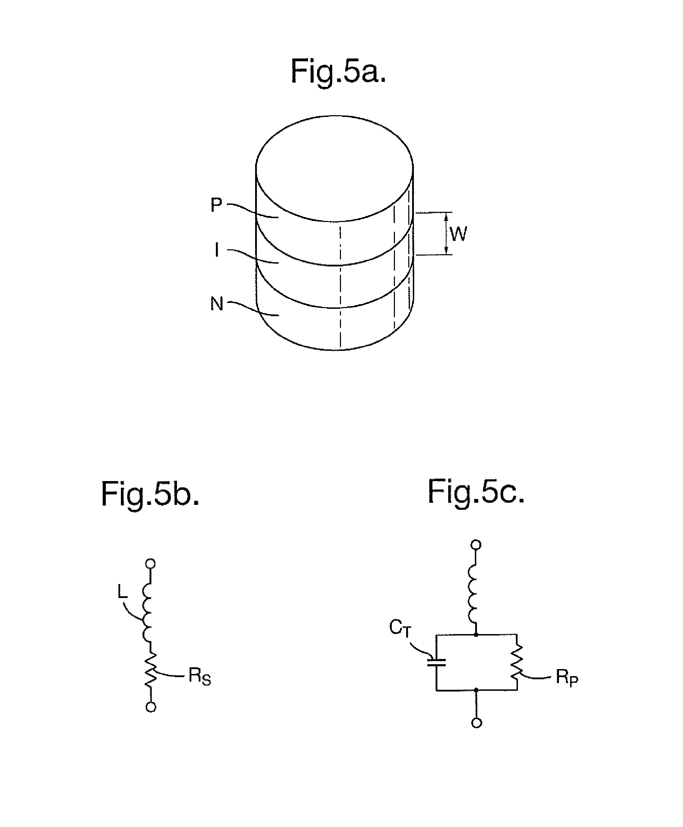

Referring to Figure 5a the basic construction of a PIN diode is illustrated, comprising a controlled thickness (W) high resistivity 'I region' located in the centre, between heavily doped N and P material. Charges from the P and N materials do not combine immediately i.e. have longer carrier life times (recombination time) due to storage as charge in the 'I region'. This results in a lower resistivity in the 'I region'. For purposes of limiter design this generates a low resistance to large microwave currents as the charge remains in the device for the period of a RF cycle, thus maintaining the low resistance limiter characteristics throughout the RF cycle. The width (W) of the 'I region' also determines the power level leakage of a PIN diode.

Figure 5b illustrates the PIN diode in forward bias with L impedance and Rₛ (series) resistance. Figure (c shows the PIN diode in reverse bias. In particular, for input signals below the limit level with the PIN diode in reverse bias the 'I region' acts as a parallel plate capacitor with small capacitance, C_{T}, typically 0.1 pF, and Rp (parallel) resistance as shown in Figure 5(c).

Moving onto the situation of a high DC reverse bias where the capacitance set up is such that the diode acts as an insulator, when there are no minority carriers present in the 'I region'. Thus in the PIN limiter design of the preferred embodiment, there will be a very low insertion loss to small microwave signals, particularly when connected in a shunt position on a micro-strip track. In the reverse bias condition with no diode junction present there will be no diode junction type noise present, thus introducing no unwanted junction noise effects.

With the embodiment described above protection for a sensitive receiver LNA is provided up to 1 W CW (Continuous wave signal)

The PIN diode limiter described provides the advantage of linear limiting by reducing the impedance to reflect power back to the source as there is no rectification process taking place. This is in contrast to the Schottky diode limiter, and hence there will be no high power harmonics to consider the design. Any harmonics from the rectification process would generate inter-modulation distortion, therefore the linear limiting process achieved from the PIN Diode Limiter is much more desirable for receiver applications.

A passive pin limiter circuit can operate satisfactorily at lower signals and microwave currents, however more control of the bias current is provided with the preferred embodiment illustrated in Figure 3. Thus the PIN Diode provides a Limit function at higher microwave currents. An active biased PIN Limiter Diode Circuit is achieved by adding an external reverse DC bias to a Passive PIN Limiter Diode, as shown in Figure 3.

The active, biased PIN Limiter Diode Circuit of Figure 3 has advantages over PIN limiter diode without bias (passive) design as the small signal insertion loss will be much less than the 0.1dB typical of a negative biased diode, since the I' region' capacitance C_{T} and the resistance Rp are greater. In addition, an active biased limiter operates at higher microwave currents and can reflect the induced high power microwave signal back to source.

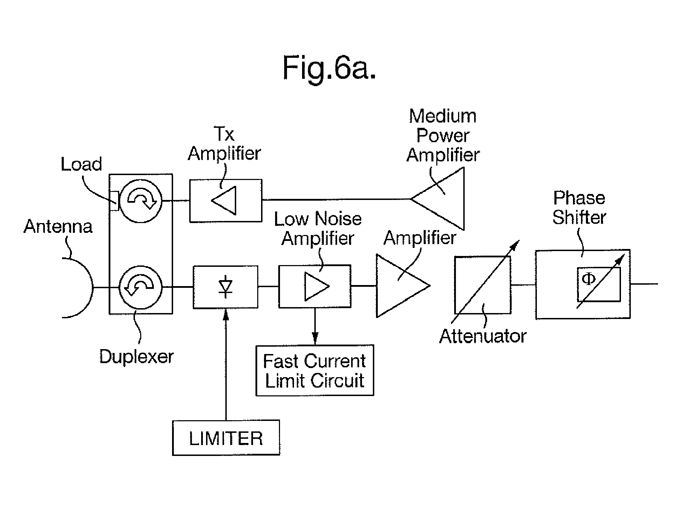

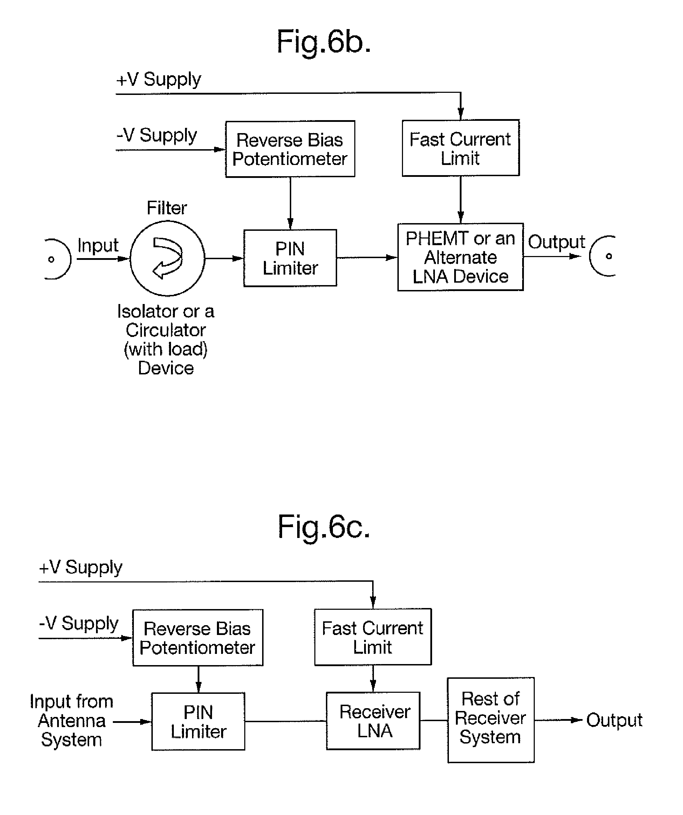

In operation, in the system of Figure 6a the characteristic of such a limiter with bias applied to the passive PIN Limiter circuit the limiter performs to specification providing flat leakage, without spiking, at +21dBm, which was maintained to within +2dBs up to an input level of +27dBm. This means that the variation in signal is constrained and the limiter has a swift limiting response due to the small size (1-2 mm) of the preferred embodiment without a large electronic charge inside the device to overcome. The spike leakage in this example was measured using a fast detector on the PIN limiter's output. The spike was measured to be 2dB above the flat leakage level and occurred for less than 4ns.

The active PIN limiter was found to provide flat leakage from around 14dBm to 19.5dBm output across the receiver's frequency bands for 20dBm to 30dBm input. The PIN limiter provides 10dBm of attenuation at 1 W microwave input power.

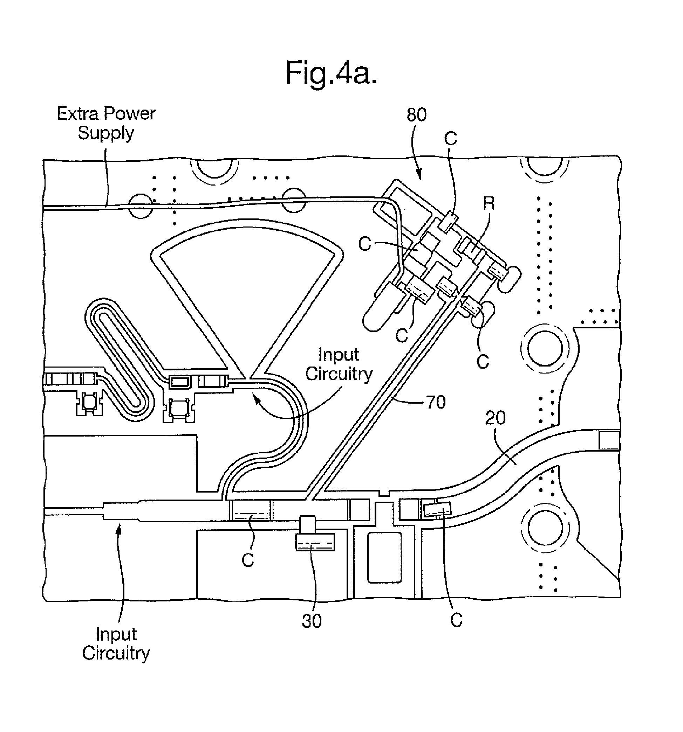

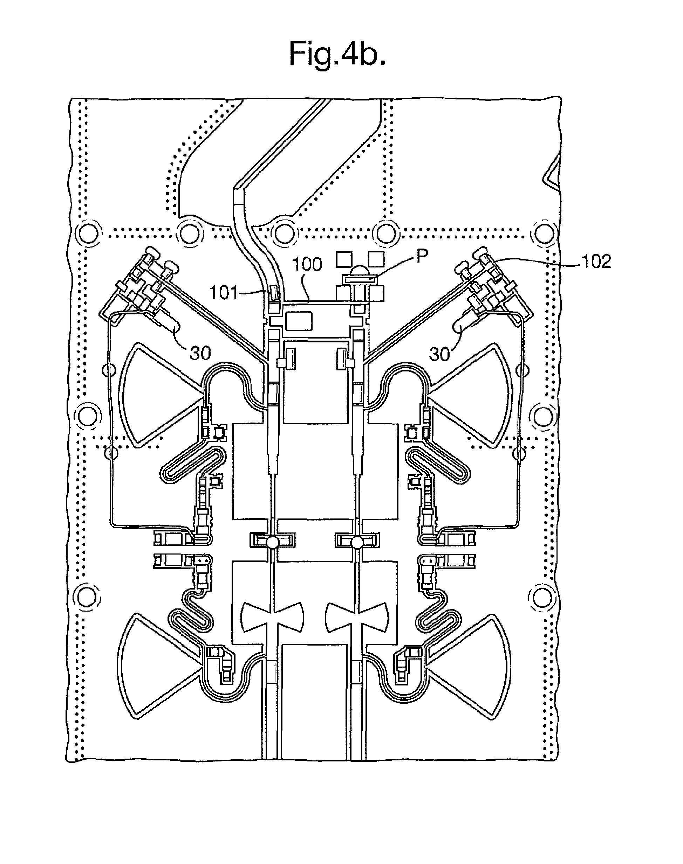

In Figures 4a and 4b the integration of a set of two of active PIN limiter devices is shown, such that they become part of the existing receiver's LNA. The circuit is also shown in Figure 6a. The PIN limiters fit into the existing layout as shown in the figures. Two extra RF coupling capacitors 100 required for the limiter were added to the input side of the hybrid coupler as shown, so as not to affect the LNA's matching circuitry present after the hybrid coupler.

The LNA is configured as a balanced dual PHEMT wideband design operating over the E/F (S band) Band frequencies, with a mismatch presented to the hybrid coupler output in order to present an RF match suitable in order to achieve the low noise figure from the low noise PHEMTs employed. The PHEMT mismatch is presented at the third terminal 101 of the coupler 102, where a 50 ohm load absorbs the RF circuit mismatch. Use can be made of this element of the design by mounting the limiter diode after the hybrid coupler. The reflected microwave power generated by the operation of the limiter will then be absorbed by the coupler's RF load at 101, 102.

The PHEMT, used within the LNA, has an input impedance of only 10 ohms; this has a huge advantage in the shunt impedance of the diode will have very little effect to the noise figure. (i.e. in the PIN limiter circuit when measured with a 50R system less then 0.1dB insertion loss should be present).

A current limiter is also present in the embodiment illustrated in Figures 4a and 4b. The limiters are added to the drain connection of both the PHEMT devices in order to prevent a large current from being drawn from the power supply, this condition would exist when a large unwanted microwave signal is present on the PHEMT input. The signal limiter here, a PIN diode limiter, acts to limit the input signal to the amplifier.

The Combined Input Filter and LNA's noise figure measured prior to the installation of the PIN Limiter was recorded at 1.3dB. The noise figure was re-measured after the installation of the PIN Limiter and was recorded at 1.3dB i.e. no visible change (increase) in the noise figure was observed.

An RF connector was added to the hybrid coupler's load terminal to check the operation of the limiter, i.e. to evaluate how much of the unwanted power was returned to the load. 28.8dBm level of fundamental and -16dBm of 2^{nd} and 3^{rd} harmonics were observed. Thus, some non-linearity is present but not as significant as a level of 0-3dBm for background of a Schottky -type limiter.

29.7dBm of mid-band CW was applied to the modified amplifier for a duration of 12 hours. Afterwards the noise figure, and gain was re-measured and no change in the LNA's performance was observed.

In addition to the preferred embodiment described above alternatives and modifications to the receiver apparatus and limiter device may be envisaged without departing from the scope of the present invention. For example, other values of component and arrangement of circuit could be used.

Mulitple sets of limiter arrangements may be used, repeating pairs for limiters may be used for limiting at higher power, the limiting device and function can be scalable for the power of the system. The limiting may act to reduce the power gradually, resulting in a gradual reduction to a flat leakage.

## Claims

1. Receiver apparatus comprising an antenna arranged to receive a signal, an amplifier arranged to amplify a said signal and a signal limiter device for limiting an input signal to the amplifier, wherein the signal limiter is integrated into the amplifier.

2. Receiver apparatus according to Claim 1, wherein the signal limiter device comprises a diode circuit.

3. Receiver apparatus according to Claim 2, wherein the signal limiter device includes an external reverse bias, preferably a potentiometer circuit.

4. Receiver apparatus according to Claim 2, wherein the diode circuit comprises an active biased PIN limiter diode.

5. Receiver apparatus according to any one of claims 1 to 4, wherein in operation the signal limiter device displays a low noise figure.

6. Receiver apparatus according to any preceding claim, wherein the signal limiter device provides a linear limiting characteristic.

7. Receiver apparatus according to any preceding claim, wherein the receiver apparatus further comprises an input and coupling circuit arranged to correspond to characteristics of the signal limiter device.

8. Receiver apparatus according to any preceding claim, further comprising a plurality of signal limiter devices.

9. Receiver apparatus according to claim 8, wherein a signal limiter device is provided at one of each of a plurality of input ports of the receiver apparatus.

10. Receiver apparatus according to claim 9, wherein an isolator means is provided at one of each of a plurality of input ports of the receiver apparatus.

11. Receiver apparatus according to any preceding claim, further comprising a fast current limiter device.

12. A radar system comprising a transmitter arranged to generate and transmit a radio signal, an antenna arranged to collect a signal returned and reflected from a target and a receiver apparatus arranged to receive a signal, wherein the receiver apparatus comprises an amplifier arranged to amplify a said signal and a signal limiter device for limiting an input signal to the amplifier, wherein the signal limiter is integrated into the amplifier circuit.

13. A method of operating a receiver apparatus of any one of claims 1 to 11.

14. A method of operating a radar system of claim 12.

15. A method of signal processing using the receiver apparatus of any one of claims 1 to 11.
